# EUROPEAN PATENT APPLICATION

(11) **EP 2 869 347 A1**
(43) Date of publication of application: **06.05.2015**
(21) Application number: 14189359.4
(22) Date of filing: 17.10.2014
(51) Int. Cl.: H01L 29/778, H01L 21/338, H01L 29/205, H01L 29/20, H01L 29/201

(54) **Group III-V device including a buffer termination body**

(30) Priority: 30.10.2013 US 201361897525 P; 02.10.2014 US 201414505252
(71) Applicant: International Rectifier Corporation, El Segundo, CA 90245 (US)
(72) Inventor: Briere, Michael A., Scottsdale, AZ 85266 (US)
(74) Representative: Dr. Weitzel & Partner

(57) **Abstract**

A III-Nitride device includes a III-Nitride buffer layer (332) situated over a substrate (310), the III-Nitride buffer layer having a first bandgap. In addition, the device includes a III-Nitride heterostructure situated over the III-Nitride buffer layer and configured to produce a two-dimensional electron gas (2DEG) (355); the III-Nitride heterostructure includes a channel layer (354) having a second bandgap smaller than the first bandgap. The III-Nitride device also includes a buffer termination body (342) situated between the III-Nitride buffer layer and the channel layer, the buffer termination body including a III-Nitride material having a third bandgap smaller than the first bandgap and larger the second bandgap.

## Description

### BACKGROUND

The present application claims the benefit of and priority to a provisional application entitled "Compositionally Graded HEMT Buffer Termination," Serial No. 61/897,525 filed on October 30, 2013. The disclosure in this provisional application is hereby incorporated fully by reference into the present application.

### I. DEFINITION

As used herein, "III-Nitride" or "III-N" refers to a compound semiconductor that includes nitrogen and at least one group III element such as aluminum (Al), gallium (Ga), indium (In), and boron (B), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N_{(1-a-b)}), aluminum indium gallium arsenide phosphide nitride (AlₓIn_{y}Ga_{(1-x-y)}AsₐP_{b}N_{(1-a-b)}), for example. III-N also refers generally to any polarity including but not limited to Ga-polar, N-polar, semi-polar, or non-polar crystal orientations. A III-N material may also include either the Wurtzitic, Zincblende, or mixed polytypes, and may include single-crystal, monocrystalline, polycrystalline, or amorphous structures. Gallium nitride or GaN, as used herein, refers to a III-N compound semiconductor wherein the group III element or elements include some or a substantial amount of gallium, but may also include other group III elements in addition to gallium. A III-N or a GaN transistor may also refer to a composite high voltage enhancement mode transistor that is formed by connecting the III-N or the GaN transistor in cascode with a lower voltage group IV transistor.

In addition, as used herein, the phrase "group IV" refers to a semiconductor that includes at least one group IV element such as silicon (Si), germanium (Ge), and carbon (C), and may also include compound semiconductors such as silicon germanium (SiGe) and silicon carbide (SiC), for example. Group IV also refers to semiconductor materials which include more than one layer of group IV elements, or doping of group IV elements to produce strained group IV materials, and may also include group IV based composite substrates such as single-crystal or polycrystalline SiC on silicon, silicon on insulator (SOI), separation by implantation of oxygen (SIMOX) process substrates, and silicon on sapphire (SOS), for example.

It is noted that, as used herein, the terms "low voltage" or "LV" in reference to a transistor or switch describes a transistor or switch with a voltage range of up to approximately fifty volts (50V). It is further noted that use of the term "midvoltage" or "MV" refers to a voltage range from approximately fifty volts to approximately two hundred volts (approximately 50V to 200V). Moreover, the term "high voltage" or "HV," as used herein, refers to a voltage range from approximately two hundred volts to approximately twelve hundred volts (approximately 200V to 1200V), or higher.

### II. BACKGROUND ART

Group III-V heterostructure field-effect transistors (HFETs), such as gallium nitride (GaN) or other III-Nitride based high mobility electron transistors (HEMTs), may be desirable for use in high power and high performance circuit applications due to their high efficiency and high-voltage capability. III-Nitride and other group III-V HEMTs operate using polarization fields to generate a two-dimensional electron gas (2DEG) allowing for high current densities with low resistive losses. Because the 2DEG can arise naturally near the interface of a III-Nitride channel layer and an overlying III-Nitride barrier layer having a larger bandgap than the channel layer, III-Nitride HEMTS typically conduct without the application of a gate potential.

In some implementations, it may be advantageous or desirable to implement a buffer layer underlying the III-Nitride channel and barrier layers using a III-Nitride material also having a larger bandgap than the channel layer. For example, use of a larger bandgap buffer layer under the channel layer may reduce the conductivity of the buffer layer, thereby reducing leakage current through the HEMT. However, such an implementation may undesirably result in a naturally arising secondary 2DEG at the interface of the channel layer and the underlying buffer layer having the larger bandgap.

### SUMMARY

The present disclosure is directed to a group III-V device including a buffer termination body, substantially as shown in and/or described in connection with at least one of the figures, and as set forth more completely in the claims.

### BRIEF DESCRIPTION OF THE DRAWINGS

Figure 1 shows a cross-sectional view of a conventional group III-V high electron mobility transistor (HEMT), depicting its ON state.
Figure 2 shows a flowchart presenting an exemplary method for forming a group III-V device including a buffer termination body, according to one implementation.
Figure 3A shows a cross-sectional view of a structure corresponding to an initial formation stage, according to one implementation of the flowchart of Figure 2.
Figure 3B shows a cross-sectional view of the structure of Figure 3A at a subsequent formation stage, according to one implementation of the flowchart of Figure 2.
Figure 3C shows a cross-sectional view of the structure of Figure 3B at a subsequent formation stage, according to one implementation of the flowchart of Figure 2.
Figure 3D shows a cross-sectional view of the structure of Figure 3C at a subsequent formation stage, according to a first exemplary implementation of the flowchart of Figure 2.
Figure 3E shows a cross-sectional view of the structure of Figure 3C at a subsequent formation stage, according to a second exemplary implementation of the flowchart of Figure 2.
Figure 3F shows a cross-sectional view of the structure of Figure 3D at a subsequent formation stage, according to the first exemplary implementation of the flowchart of Figure 2.
Figure 3G shows a cross-sectional view of the structure of Figure 3E at a subsequent formation stage, according to the second exemplary implementation of the flowchart of Figure 2.
Figure 3H shows a cross-sectional view of the structure of Figure 3F at a subsequent formation stage, according to the first exemplary implementation of the flowchart of Figure 2.
Figure 3I shows a cross-sectional view of the structure of Figure 3G at a subsequent formation stage, according to the second exemplary implementation of the flowchart of Figure 2.

### DETAILED DESCRIPTION

The following description contains specific information pertaining to implementations in the present disclosure. One skilled in the art will recognize that the present disclosure may be implemented in a manner different from that specifically discussed herein. The drawings in the present application and their accompanying detailed description are directed to merely exemplary implementations. Unless noted otherwise, like or corresponding elements among the figures may be indicated by like or corresponding reference numerals. Moreover, the drawings and illustrations in the present application are generally not to scale, and are not intended to correspond to actual relative dimensions.

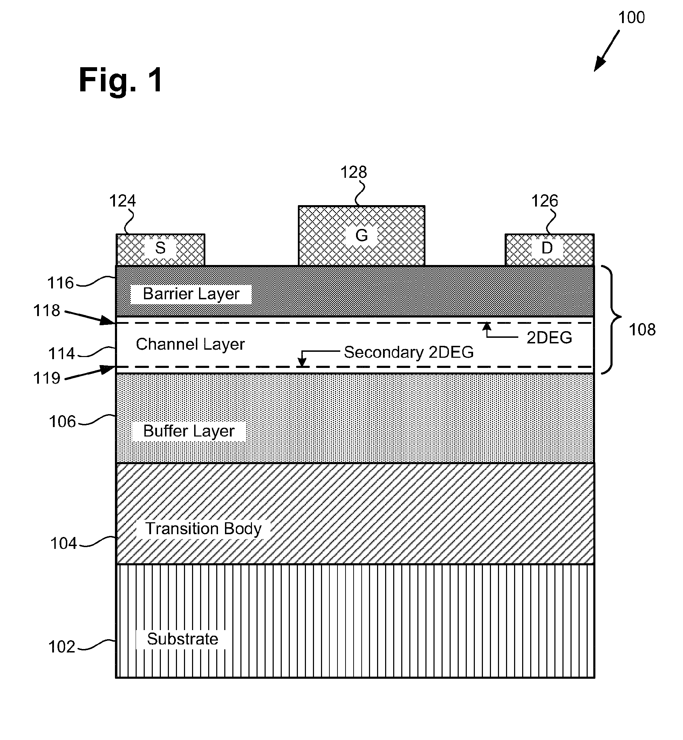

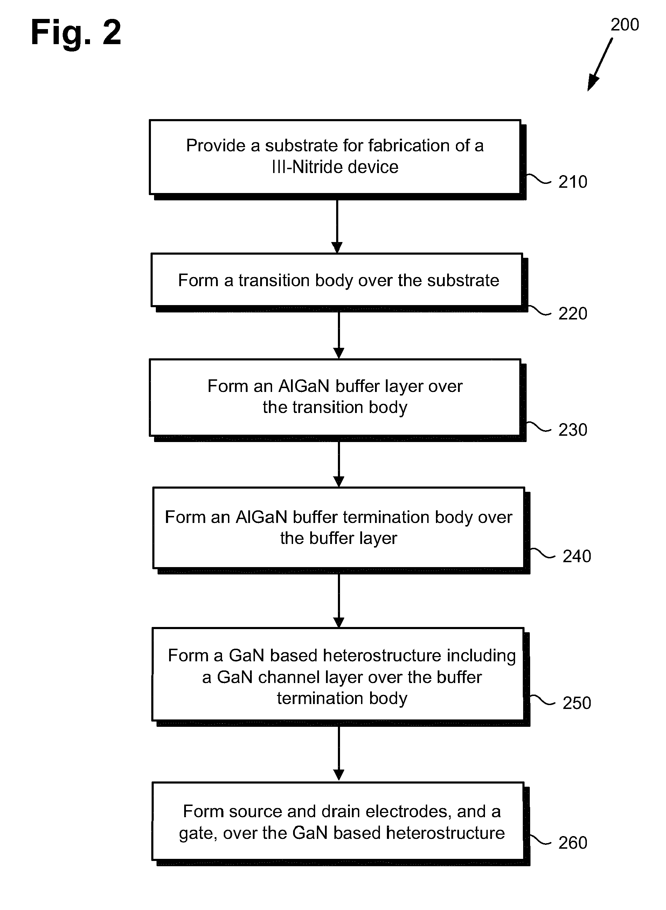

Figure 1 shows a cross-sectional view of a conventional high electron mobility transistor (HEMT), depicting its conducting or ON state. HEMT 100 includes substrate 102, transition body 104, buffer layer 106, heterostructure 108 including channel layer 114 and overlying barrier layer 116, source electrode 124, drain electrode 126, and gate 128. As shown in Figure 1, in its ON state, HEMT 100 includes two-dimensional electron gas (2DEG) 118 providing a desired conduction channel for the charge carriers of HEMT 100 between source electrode 124 and drain electrode 126, which are ohmic contacts. As further shown in Figure 1, 2DEG 118 is generated in heterostructure 108 at or near the interface of channel layer 114 and barrier layer 116 having a larger bandgap than channel layer 114. Also shown in Figure 1 is secondary 2DEG 119, which, in some implementations may be undesirably generated at or near the interface of channel layer 114 and buffer layer 106. It is noted that, in some instances, the undesirable conduction channel depicted as secondary 2DEG 119 may in fact take the form of a two-dimensional hole gas (2DHG) of positive charge carriers.

As illustrated by Figure 1, 2DEG 118 produced by heterostructure 108 can provide a desired, continuous, uninterrupted channel for the flow of current between source electrode 124 and drain electrode 126. As known in the art, 2DEG 118 may arise naturally, without the application of a gate potential to gate 126, resulting in HEMT 100 being a normally ON, depletion mode, device. Moreover, and as noted above, in some implementations, it may be advantageous or desirable to implement buffer layer 106 using a semiconductor material having a larger bandgap than channel layer 114. For example, and as further noted above, use of buffer layer 106 having a larger bandgap than channel layer 114 may reduce the conductivity of buffer layer 106 and provide a barrier for conduction between drain electrode 126 and the layer or layers underlying buffer layer 106, thereby reducing the level of leakage current through HEMT 100. However, such an implementation may result in undesirable secondary 2DEG 119, or a corresponding undesirable 2DHG, appearing as a naturally arising feature at or near the interface of channel layer 114 and buffer layer 106.

The present application is directed to group III-V heterostructure field-effect transistors (HFETs), such as III-Nitride or other group III-V HEMTs, configured to reduce or substantially suppress formation of an undesirable secondary 2DEG, or an undesirable 2DHG, corresponding to secondary 2DEG 119, in Figure 1. The present inventive concepts include formation of a buffer termination body to mediate the interface of a heterostructure channel layer and an underlying buffer layer having a larger bandgap than the channel layer. The buffer termination body is situated between the channel layer and the buffer layer having the larger bandgap, and is formed such that polarization charges at the interface of the channel layer and buffer termination body do not form an effective 2DEG or 2DHG. Moreover, the buffer termination body and underlying buffer layer(s) are configured to have larger bandgaps than the channel layer in order to continue to provide improved punch-through capability and reduced device leakage.

Referring to Figure 2, Figure 2 shows flowchart 200 presenting an exemplary method for forming a group III-V device including a buffer termination body configured to overcome the drawbacks and deficiencies associated with HEMT 100, in Figure 1. Certain details and features have been left out of flowchart 200 that are apparent to a person of ordinary skill in the art in order not to obscure the discussion of the inventive features in the present application.

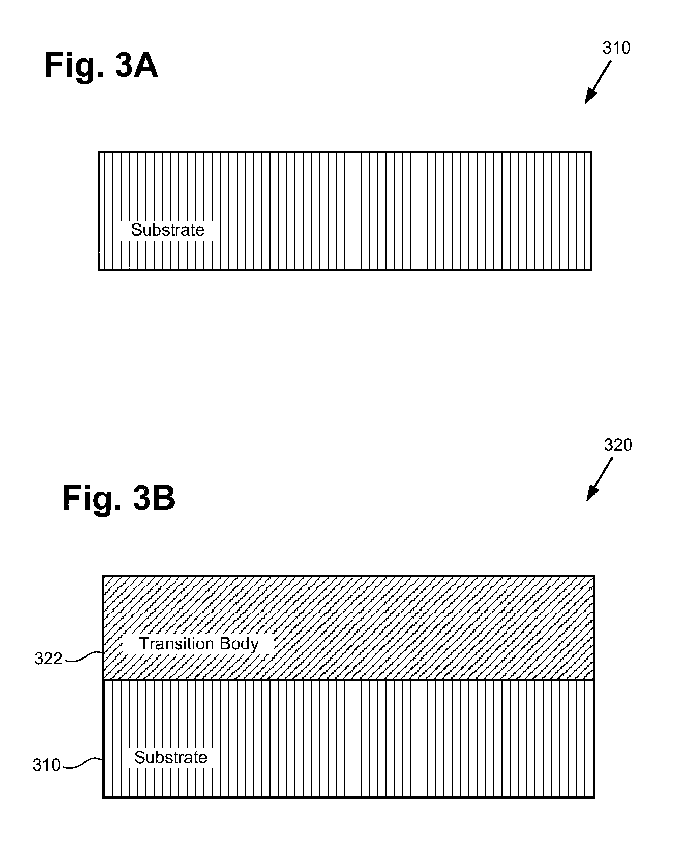

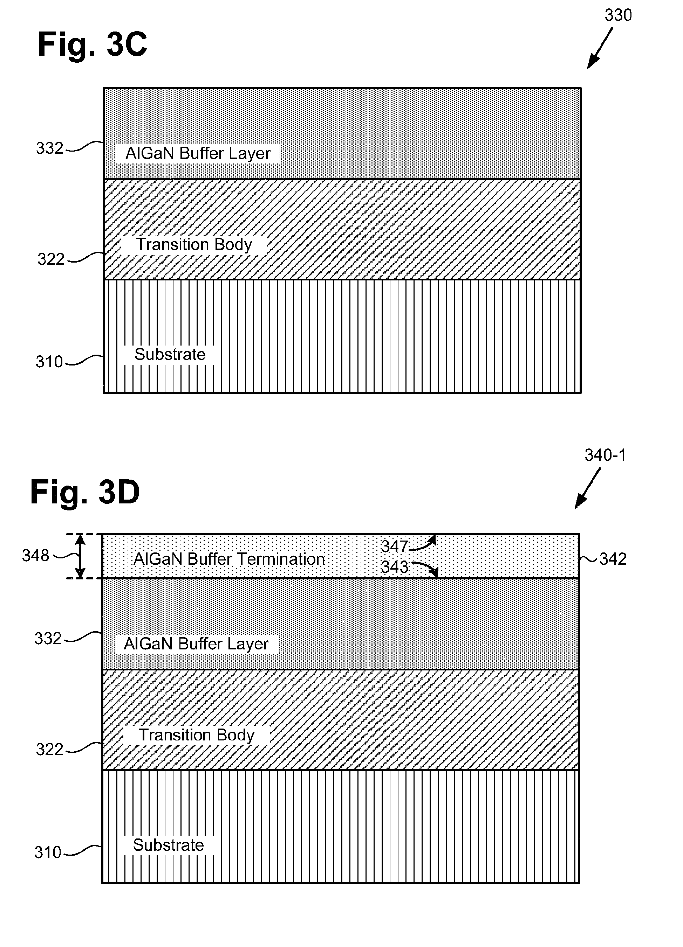

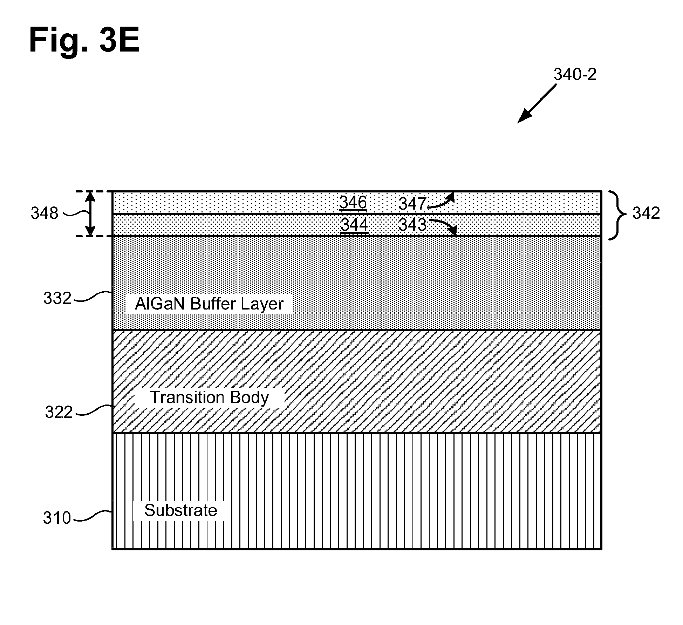

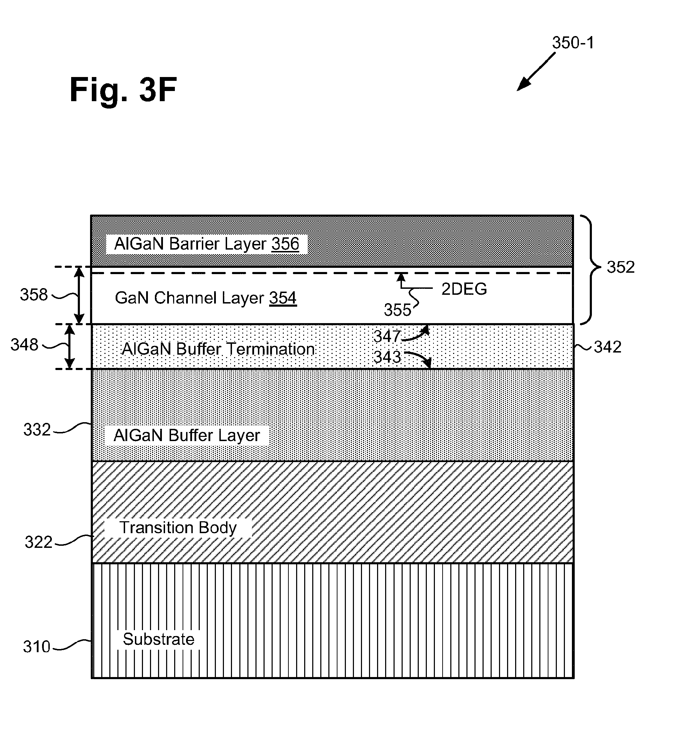

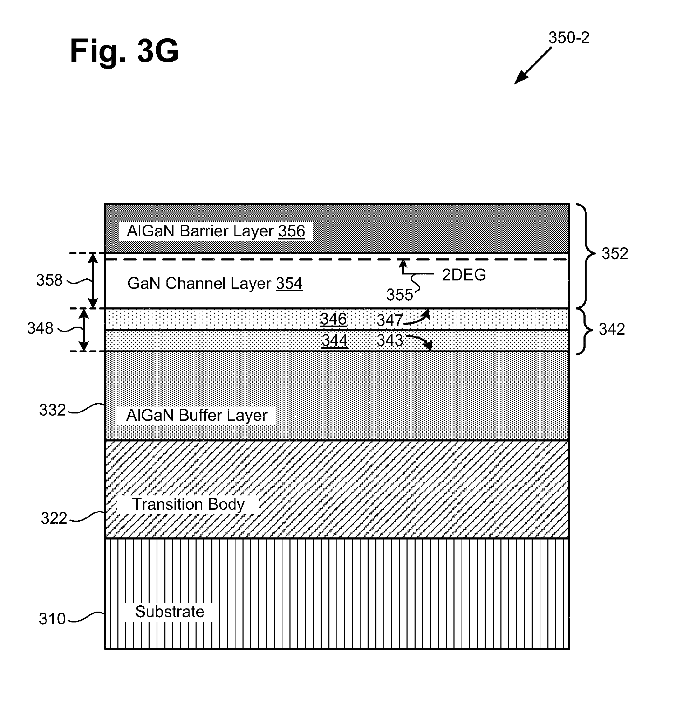

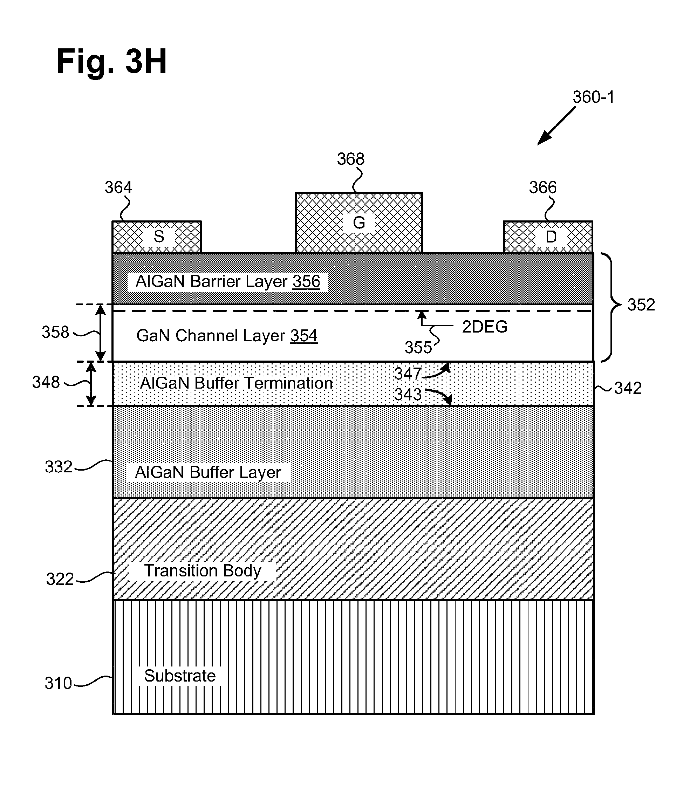

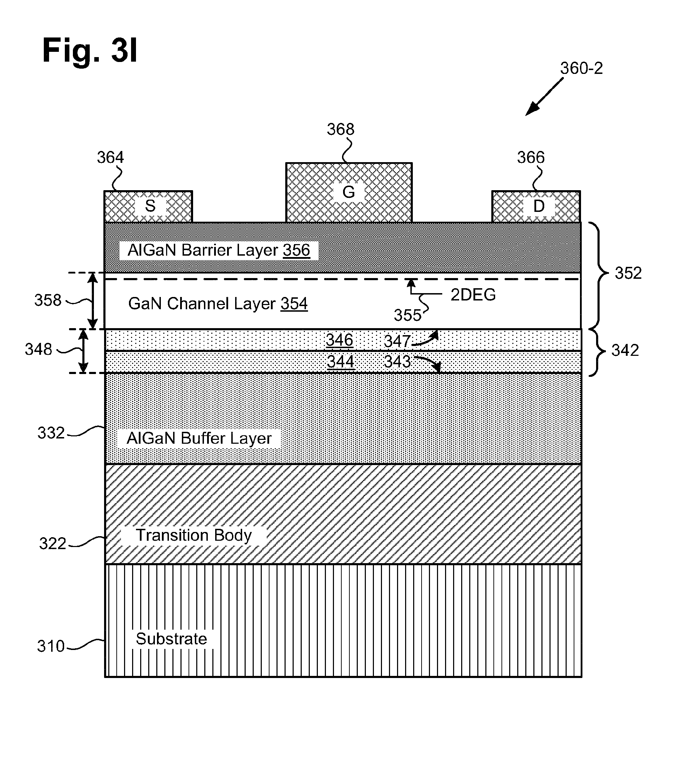

Referring now to Figure 3A, Figure 3A shows a cross-sectional view of substrate 310. In particular, substrate 310 is selected so as to be suitable for use as a support substrate for a group III-V HEMT. Proceeding on to Figures 3B and 3C, structures 320, and 330 show the result of forming a transition body (220) and forming an aluminum gallium nitride (AlGaN) buffer layer (230), respectively, over substrate 310. Moreover, Figures 3D, 3F, and 3H show continued formation of the group III-V HEMT having a buffer termination body according to a first exemplary implementation, while Figures 3E, 3G, and 3I show formation of such a device according to a second exemplary implementation.

It is noted that the structures shown in Figures 3A, 3B, 3C, 3D, 3E, 3F, 3G, 3H, and 3I (hereinafter "Figures 3A through 3I") are provided as specific implementations of the present inventive principles, and are shown with such specificity for the purposes of conceptual clarity. It should also be understood that particular details such as the materials used to form the structures shown in Figures 3A through 3I, and the techniques used to produce the various depicted features, are being provided merely as examples, and should not be interpreted as limitations.

Referring to Figure 3A in conjunction with Figure 2, flowchart 200 begins with providing substrate 310 for fabrication of a III-Nitride or other group III-V device (210). Substrate 310 may include any material suitable for use as a substrate for fabrication of a group III-V device. For example, substrate 310 may be formed of a group IV material such as silicon (Si), or may be a silicon carbide (SiC) or sapphire substrate. Alternatively, in some implementations, substrate 310 may be a native substrate for the materials from which the group III-V device is to be fabricated, such as a native gallium nitride (GaN) or other III-Nitride substrate, for instance. Moreover, although substrate 310 is shown as a substantially unitary substrate, in other implementations, substrate 310 may correspond to a silicon on insulator (SOI) substrate, a separation by implantation of oxygen (SIMOX) process substrate, a silicon on sapphire (SOS) substrate, or a single-crystal or polycrystalline SiC on silicon substrate, for example.

Turning to Figure 3B with further reference to Figure 2, flowchart 200 continues with forming transition body 322 over substrate 310 (220). As shown by structure 320 in Figure 3B, in implementations in which substrate 310 is not a native substrate for fabrication of a group III-V HEMT, transition body 322 may be formed over substrate 310. As a specific example, where substrate 310 is a silicon substrate, transition body 322 may correspond to multiple distinguishable layers mediating the lattice transition from substrate 310 to a group III-V material layer.

In one implementation, transition body 322 may include a nucleation layer (nucleation layer not shown in Figure 3B), in addition to layers formed so as to reduce the net mismatch in thermal coefficient of expansion between substrate 310 and later formed group III-V active layers. For instance, when forming a GaN based HEMT, transition body 322 may include an aluminum nitride (AlN) layer formed on substrate 310, or on a stress reducing layer and/or a nucleation layer formed on substrate 310, and may further include a series of AlGaN layers having a progressively reduced aluminum content relative to their gallium content, until a suitable transition to an overlying buffer layer is achieved. Moreover, in some implementations, transition body 322 may take the form of a compositionally graded body having different group III-V alloy compositions at respective top and bottom surfaces.

Examples of using a compositionally graded transition body, as well as use of intermediate layers, stress reducing layers, and various interlayers are disclosed in U.S.

Patent Number 6,649,287, entitled "Gallium Nitride Materials and Methods", and issued on November 18, 2003; U.S. Patent Number 6,617,060, also entitled "Gallium Nitride Materials and Methods", and issued on September 9, 2003; U.S. Patent Number 7,339,205, entitled "Gallium Nitride Materials and Methods Associated with the Same", and issued on March 4, 2008; U.S. Patent Application Number 12/928,946, entitled "Stress Modulated Group III-V Semiconductor Device and Related Method", and filed on December 21, 2010; U.S. Patent Application Number 13/397,190, entitled "III-Nitride Heterojunction Devices Having a Multilayer Spacer", and filed on February 15, 2012; and U.S. Patent Application Number 11/531,508, entitled "Process for Manufacture of Super Lattice Using Alternating High and Low Temperature Layers to Block Parasitic Current Path", and filed on September 13, 2006; and U.S. Patent Application Number 13/405,180, entitled "III-Nitride Semiconductor Structures with Strain Absorbing Interlayer Transition Modules", and filed on February 24, 2012. The above-referenced patents and patent applications are hereby incorporated fully by reference into the present application.

Moving to Figure 3C with further reference to Figure 2, flowchart 200 continues with forming AlGaN buffer layer 332 over transition body 322 (230), as shown by structure 330. AlGaN buffer layer 332 may be formed over transition body 322 using any of a number of known growth techniques. For example, AlGaN buffer layer may be formed over transition body 322 using molecular-beam epitaxy (MBE), metalorganic chemical vapor deposition (MOCVD), or hydride vapor phase epitaxy (HVPE), to name a few suitable approaches.

Continuing to Figure 3D, flowchart 200 continues with forming AlGaN buffer termination body 342 over AlGaN buffer layer 332 (240), as shown in a first exemplary implementation by structure 340-1. As shown in Figure 3D, AlGaN buffer termination body 342 has bottom surface 343 situated over AlGaN buffer layer 332, top surface 347 opposite bottom surface 343, and thickness 348. AlGaN buffer termination body 342 may be formed over AlGaN buffer layer 332 using any of MBE, MOCVD, or HVPE, for example. It is reiterated that AlGaN buffer termination body 342 is represented as an AlGaN body for merely exemplary purposes. More generally, a buffer termination body corresponding to AlGaN buffer termination body 342 may be formed of any suitable III-Nitride or other group III-V material.

In one implementation, AlGaN buffer termination body 342 may take the form of a single AlGaN layer of substantially uniform composition. However, in other implementations, AlGaN buffer termination body 342 may be formed as a compositionally graded layer, such as a compositionally graded AlGaN or other III-Nitride or group III-V layer having a smaller bandgap at top surface 347 and a larger bandgap at bottom surface 343. For example, in implementations in which the buffer termination body is formed of AlGaN, as depicted in Figure 3D, AlGaN buffer termination body 342 may be formed as a compositionally graded AlGaN layer having a lower aluminum concentration at top surface 347 and a greater aluminum concentration at bottom surface 343.

Referring to Figure 3E, structure 340-2 shows formation of AlGaN buffer termination body 342 over AlGaN buffer layer 332 (240), according to a second exemplary implementation. As shown in Figure 3E, a buffer termination body corresponding to AlGaN buffer termination body 342 may include multiple AlGaN or other III-Nitride layers. For example, AlGaN buffer termination body 342 may include first AlGaN or other III-Nitride or group III-V layer 344 having a first alloy composition and second AlGaN or other III-Nitride or group III-V layer 346 having a second alloy composition.

In some implementations, as shown in Figure 3E, AlGaN buffer termination body 342 may include first AlGaN or other III-Nitride or group III-V layer 344 and second AlGaN or other III-Nitride or group III-V layer 346 situated over first layer 344, wherein a bandgap of first layer 344 is larger than a bandgap of second layer 346. For example, in implementations in which a buffer termination body corresponding to buffer termination body 342 is formed of AlGaN, as depicted in Figure 3E, first AlGaN layer 344 may have an aluminum concentration that is greater than the aluminum concentration of overlying second AlGaN layer 346.

In some implementations, it may be advantageous or desirable to include one or more impurity graded layers in AlGaN buffer termination body 342 of either or both of structures 340-1 and 340-2 and/or AlGaN buffer layer(s) 332. Examples of impurity graded layers are disclosed in U.S. Patent Number 8,796,738, entitled "Group III-V Device Structure Having a Selectively Reduced Impurity Concentration", and issued on August 5, 2014. This patent is hereby incorporated fully by reference into the present application.

Moving to Figure 3F, flowchart 200 continues with forming GaN based heterostructure 352 including GaN channel layer 354 and AlGaN barrier layer 356 over AlGaN buffer termination body 342 (250), as shown in the first exemplary implementation of structure 350-1. As shown in Figure 3F, heterostructure 352 is configured to produce 2DEG 355 at or near the interface of GaN channel layer 354 and AlGaN barrier layer 356. As further shown in Figure 3F, GaN channel layer 354 has thickness 358. GaN channel layer 354 and AlGaN barrier layer 356 may be formed using any of MBE, MOCVD, or HVPE, for example.

It is noted that in certain implementations, it may be desirable to form AlGaN barrier layer 356 over a spacer layer (or layers) disposed between AlGaN barrier layer 356 and GaN channel layer 354. Examples of using such spacer layer(s) are disclosed in U.S. Patent Number 8,659,030, entitled "III-Nitride Heterojunction Devices Having a Multilayer Spacer", and issued on February 25, 2014. This patent is hereby incorporated fully by reference into the present application. Moreover, in some implementations, it may be advantageous or desirable to use a thin layer of AlN or high Al content AlGaN in conjunction with AlGaN barrier layer 356 to aid in confinement of 2DEG 355.

Channel layer 354 and barrier layer 356 are depicted as respective GaN and AlGaN layers for exemplary purposes only. More generally, channel layer 354 and barrier layer 356 can be implemented using any suitable III-Nitride or other group III-V layers for which barrier layer 356 has a bandgap sufficiently larger than the bandgap of channel layer 354 to produce 2DEG 355. In addition, and to reduce or substantially suppress an undesirable secondary 2DEG, or an undesirable 2DHG, from forming in heterostructure 352, buffer termination body 342 is situated between buffer layer 332 and channel layer 354, and has a bandgap smaller than the bandgap of buffer layer 332 and larger than the bandgap of channel layer 354.

For example, in implementations in which channel layer 354 takes the form of a GaN channel layer including substantially no aluminum, leakage in buffer layer 332 may be advantageously reduced when buffer layer 332 is implemented as an AlGaN buffer layer having an aluminum concentration of approximately four percent (4%), or greater. In such an implementation, buffer termination body 342 may be a compositionally graded AlGaN layer having an aluminum concentration of approximately 1% or less at top surface 347 and an aluminum concentration of from approximately 2% to approximately 4% at bottom surface 343.

It is noted that, as used herein, the expression "substantially suppress an undesirable secondary 2DEG" refers to the fact although a secondary 2DEG, or a 2DHG, may appear at or near the interface of channel layer 354 and buffer termination body 342, that secondary 2DEG, or 2DHG, is not an effective conduction channel. That is to say, the available density of charge carrier states that could be filled at or near the interface of channel layer 354 and buffer termination body 342 is less than approximately 10% of the available density of electron states formed in desirable 2DEG 355. As a result, that weak (or ineffective) secondary 2DEG, or 2DHG, has negligible affect on the performance of the resulting HEMT, and is therefore characterized as being substantially suppressed.

Referring to Figure 3G, structure 350-2 shows formation of GaN based heterostructure 352 over AlGaN buffer termination body 342 (250), according to the second exemplary implementation. As shown in Figure 3G, AlGaN buffer termination body 342 may include multiple AlGaN layers having different aluminum concentrations. For example, in implementations in which channel layer 354 takes the form of a GaN channel layer including substantially no aluminum, as described above, and buffer layer 332 is implemented as an AlGaN buffer layer having an aluminum concentration of approximately 4%, or greater, first AlGaN layer 344 may have an aluminum concentration of approximately 2%, or between approximately 2% and approximately 4%, while second AlGaN layer 346 may have an aluminum concentration of approximately 1% or less.

In some implementations, it may be advantageous or desirable to form buffer termination body 342 of either or both of structures 350-1 and 350-2 so as to have a thin sharp grade. For example, buffer termination body 342 and channel layer 354 may be formed such that thickness 348 of buffer termination body 342 is less than or approximately equal to thickness 358 of channel layer 354. In such implementations, the sum of thickness 348 and thickness 358 may be expected to be sufficiently thin to be punch-through resistant. Thus, buffer termination body 342 can be configured such that it reduces or substantially suppresses the undesirable formation of a secondary 2DEG at or near its interface with channel layer 354, while concurrently providing improved punch-through capability and reduced device leakage.

Moving to Figure 3H and Figure 3I, flowchart 200 concludes with forming source electrode 364, drain electrode 366, and gate 368 over heterostructure 352 (260), as shown in the first and second exemplary implementations of respective structures 360-1 and 360-2. Source electrode 364 and drain electrode 366 may be formed of any suitable conductive material, and are formed so as to make ohmic contact with heterojunction 352. Gate 368 may be implemented as a Schottky gate making Schottky contact with barrier layer 356, or as an insulated gate including a gate dielectric (gate dielectric not shown in Figures 3H and 3I) and being capacitively coupled to barrier layer 356. The resulting HEMT corresponding to either or both of structures 360-1 and 360-2 may be implemented as a midvoltage or high voltage device, as defined above in the Definition section of the present application.

Thus, the present application discloses group III-V HEMTs configured to reduce or substantially suppress formation of an undesirable secondary 2DEG. Such reduction or substantial suppression is achieved by situating a buffer termination body having a bandgap larger than that of a channel layer and smaller than that of a buffer layer, between the channel layer and the buffer layer. As a result, the polarization charges at the interface of the channel layer and buffer termination body do not form an effective secondary 2DEG. Moreover, the buffer termination body is configured to have a larger bandgap than the channel layer in order to continue to provide improved punch-through capability and reduced device leakage.

From the above description it is manifest that various techniques can be used for implementing the concepts described in the present application without departing from the scope of those concepts. Moreover, while the concepts have been described with specific reference to certain implementations, a person of ordinary skill in the art would recognize that changes can be made in form and detail without departing from the scope of those concepts. As such, the described implementations are to be considered in all respects as illustrative and not restrictive. It should also be understood that the present application is not limited to the particular implementations described herein, but many rearrangements, modifications, and substitutions are possible without departing from the scope of the present disclosure.

## Claims

1. A III-Nitride device comprising:
a III-Nitride buffer layer situated over a substrate, said III-Nitride buffer layer having a first bandgap;
a III-Nitride heterostructure situated over said III-Nitride buffer layer and configured to produce a two-dimensional electron gas (2DEG), said III-Nitride heterostructure including a channel layer having a second bandgap smaller than said first bandgap;
a buffer termination body situated between said III-Nitride buffer layer and said channel layer, said buffer termination body comprising a III-Nitride material having a third bandgap smaller than said first bandgap and larger than said second bandgap.

2. The III-Nitride device of claim 1, wherein said buffer termination body comprises a compositionally graded III-Nitride layer.

3. The III-Nitride device of claim 1, wherein said buffer termination body comprises a compositionally graded III-Nitride layer having a smaller bandgap at a top surface and a larger bandgap at a bottom surface.

4. The III-Nitride device of claim 1, wherein said buffer termination body comprises at least a first III-Nitride layer having a first III-Nitride composition and a second III-Nitride layer having a second III-Nitride composition.

5. The III-Nitride device of claim 1, wherein said buffer termination body comprises at least a first III-Nitride layer and a second III-Nitride layer situated over said first III-Nitride layer, wherein a bandgap of said first III-Nitride layer is larger than a bandgap of said second III-Nitride layer.

6. The III-Nitride device of claim 1, wherein a thickness of said buffer termination body is less than or approximately equal to a thickness of said channel layer.

7. The III-Nitride device of claim 1, wherein said III-Nitride buffer layer and said buffer termination body comprise aluminum gallium nitride (AlGaN).

8. A III-Nitride device comprising:
a III-Nitride buffer layer formed over a substrate, said III-Nitride buffer layer having a first aluminum concentration;
a III-Nitride heterostructure situated over said III-Nitride buffer layer and configured to produce a two-dimensional electron gas (2DEG), said III-Nitride heterostructure including a channel layer comprising substantially no aluminum;
a buffer termination body situated between said III-Nitride buffer layer and said channel layer, said buffer termination body comprising aluminum and having a second aluminum concentration less than said first aluminum concentration.

9. The III-Nitride device of claim 8, wherein said buffer termination body comprises a compositionally graded III-Nitride layer.

10. The III-Nitride device of claim 8, wherein said buffer termination body comprises a compositionally graded III-Nitride layer having a lower aluminum concentration at a top surface and a greater aluminum concentration at a bottom surface.

11. The III-Nitride device of claim 8, wherein said buffer termination body comprises at least a first III-Nitride layer having a first III-Nitride composition and a second III-Nitride layer having a second III-Nitride composition.

12. The III-Nitride device of claim 8, wherein said buffer termination body comprises at least a first III-Nitride layer and a second III-Nitride layer situated over said first III-Nitride layer, wherein an aluminum concentration of said first III-Nitride layer is greater than an aluminum concentration of said second III-Nitride layer.

13. The III-Nitride device of claim 8, wherein a thickness of said buffer termination body is less than or approximately equal to a thickness of said channel layer.

14. The III-Nitride device of claim 8, wherein said III-Nitride buffer layer and said buffer termination body comprise aluminum gallium nitride (AlGaN).

15. A method of forming a III-Nitride device, said method comprising:
forming a III-Nitride buffer layer having a first bandgap over a substrate;
forming a buffer termination body over said III-Nitride buffer layer;
forming a III-Nitride heterostructure over said buffer termination body, said III-Nitride heterostructure configured to produce a two-dimensional electron gas (2DEG), said III-Nitride heterostructure including a channel layer having a second bandgap smaller than said first bandgap;
wherein said buffer termination body has a third bandgap smaller than said first bandgap and larger than said second bandgap.
